# EUROPEAN PATENT APPLICATION

(11) **EP 2 522 931 A1**
(43) Date of publication of application: **14.11.2012**
(21) Application number: 11731754.5
(22) Date of filing: 05.01.2011
(51) Int. Cl.: F25B 1/00, F24F 1/24

(54) **REFRIGERATION DEVICE**

(30) Priority: 05.01.2010 JP 2010000686
(71) Applicant: Daikin Industries, Ltd., Osaka-shi, Osaka 530-8323 (JP)
(72) Inventor: KIDO, Naohiro, Kusatsu-shi Shiga 525-8526 (JP); MAEDA, Toshiyuki, Kusatsu-shi Shiga 525-8526 (JP)
(74) Representative: HOFFMANN EITLE
(86) International application number: PCT/JP2011/000010
(87) International publication number: WO 2011/083756

(57) **Abstract**

A refrigeration apparatus includes: a refrigerant circuit (20) to which a compressor (30) is connected, and which performs a refrigerating cycle; an electronic part (56, 57, 59) including a power module (56); and a cooling member (60) in which a refrigerant of the refrigerant circuit (20) flows, and which contacts the power module (60) so that the power module (56) is cooled by the refrigerant. The cooling member (60) of the refrigeration apparatus (10) is provided with a thermal insulation layer (65) that prevents cold heat of the refrigerant flowing in the cooling member (60) from being transferred to the outside from at least a non-contact surface (60b) other than a contact surface (60a) of the cooling member (60) with the power module (56).

## Description

### TECHNICAL FIELD

The present invention relates to refrigeration apparatuses that perform a refrigeration cycle, and more particularly to refrigeration apparatuses that cool a power module by a cooling member.

### BACKGROUND ART

Conventionally, refrigeration apparatuses are known which use a refrigerant to cool a power module of a power source that supplies electric power to a compressor. For example, Patent Document 1 discloses a cooling member including a refrigerant pipe which is comprised of copper and in which a refrigerant flows, and a flat plate-like main body which is comprised of a metal having high thermal conductivity, such as aluminum, and which has the refrigerant pipe embedded therein.

In this cooling member, the main body is made to thermally contact a power module so that heat of the power module is transferred via the main body to the refrigerant flowing through the refrigerant pipe. This cooling member can cool the power module in this manner.

### CITATION LIST

### PATENT DOCUMENT

PATENT DOCUMENT 1: Japanese Patent No. 3641422

### SUMMARY OF THE INVENTION

### TECHNICAL PROBLEM

Electronic parts such as a power module are typically accommodated in a housing of a control board etc. In such a configuration, the temperature in a region around the cooling member in the housing tends to fall when cooling the power module etc. in the housing by the cooling member. As a result, water vapor in air around the main body condenses into water droplets. Such water droplets may lead to failure of the power module or other electronic parts (e.g., a capacitor, a reactor, etc.) when they contact these electronic parts.

The present invention was developed in view of the above problem, and it is an object of the present invention to suppress occurrence of dew condensation in a refrigeration apparatus including a cooling member that cools a power module etc., so that water droplets formed by dew condensation do not contact electronic parts.

### SOLUTION TO THE PROBLEM

The prevent invention is intended for a refrigeration apparatus including: a refrigerant circuit (20) to which a compressor (30) is connected, and which performs a refrigerating cycle; an electronic part (56, 57, 59) including a power module (56); and a cooling member (60) in which a refrigerant of the refrigerant circuit (20) flows, and which contacts the power module (56) so that the power module (56) is cooled by the refrigerant. The following solution is provided.

That is, according to a first .invention, the cooling member (60) includes a preventing unit that prevents cold heat of the refrigerant flowing in the cooling member (60) from being transferred to outside from at least a non-contact surface (60b) other than a contact surface (60a) of the cooling member (60) with the power module (56).

In the first invention, the refrigerant compressed in the compressor (30) circulates in the refrigerant circuit (20) to perform the refrigeration cycle. The cooling member (60) cools the power module (56) by using the refrigerant of the refrigerant circuit (20). Specifically, the refrigerant flows in the main body (61) in the cooling member (60). Heat of the power module (56) is transferred via the main body (61) to the refrigerant flowing in the main body (61). Thus, the power module (56) is cooled.

Outside air does not flow on the contact surface (60a) between the cooling member (60) and the power module (56). Thus, dew condensation does not occur even if the cold heat of the refrigerant is transferred to the contact surface (60a), and the power module (56) is cooled by the cold heat transferred thereto. On the other hand, if the cold heat of the refrigerant is transmitted from the non-contact surface (60b) other than the contact surface (60a) between the cooling member (60) and the power module (56), air around the non-contact surface (60b) is cooled, and dew condensation may occur.

In the first invention, the cooling member (60) includes the preventing unit that prevents the cold heat of the refrigerant flowing in the cooling member (60) from being transferred to the outside from the non-contact surface (60b) other than the contact surface (60a) of the cooling member (60) with the power module (56). Thus, when the refrigerant flows in the cooing member (60) to cool the power module (56), the cold heat of the refrigerant is not transferred from the non-contact surface (60b) other than the contact surface (60a) of the cooling member (60) with the power module (56), whereby cooling of air around the cooling member (60) is suppressed. Thus, no dew condensation occurs around the cooling member (60), and the possibility is reduced that water droplets formed by dew condensation may flow toward the electronic part (56, 57, 59).

According to a second invention, the cooling member (60) includes a main body (61) in which a cooling refrigerant configured to cool the power module (56) flows, and which contacts the power module (56), and the preventing unit is formed by a thermal insulation layer (65) that covers a non-contact surface other than a contact surface (61s) of the main body (61) with the power module (56).

In the second invention, when the refrigerant flows in the main body (61) of the cooling member (60) to cool the power module (56), the thermal insulation layer (65) prevents cold heat of the cooling refrigerant from being transferred to the outside from the non-contact surface other than the contact surface (61 s) of the main body (61) with the power module (56). That is, the thermal insulation layer (65) prevents the cold heat of the cooling refrigerant from being transferred to the outside from at least the non-contact surface other than the contact surface (60a) of the cooling member (60) with the power module (56).

According to a third invention, in the first invention, the preventing unit includes a high temperature refrigerant flow path (61b) in which a high temperature refrigerant flows, and the high temperature refrigerant flow path (61b) is formed on a side of the non-contact surface (60b) with respect to a cooling refrigerant flow path (61 a) of the cooling member (60) in which the cooling refrigerant flows.

In the third invention, a portion of the cooling member (60), which is located on the side of the non-contact surface (60b) with respect to the cooling refrigerant flow path (61 a), is heated by the high temperature refrigerant flowing in the high temperature refrigerant flow path (61b). Thus, the cold heat of the cooling refrigerant flowing in the cooling refrigerant flow path (61a) is absorbed by the high temperature refrigerant flowing in the high temperature refrigerant flow path (61b) located on the side of the non-contact surface (60b) with respect to the cooling refrigerant flow path (61a), or by a high temperature portion heated by the high temperature refrigerant. Thus, the cold heat of the cooling refrigerant is prevented from being transferred to the outside from the non-contact surface (60b) other than the contact surface (60a) of the cooling member (60) with the power module (56), and the non-contact surface (60b) is heated to a high temperature by heat of the high temperature refrigerant flowing in the high temperature refrigerant flow path (61b). This suppresses occurrence of dew condensation around the cooling member (60).

According to a fourth invention, in the third invention, the preventing unit has a thermal insulation layer (68) formed between the cooling refrigerant flow path (61a) and the high temperature refrigerant flow path (61b).

In the fourth invention, the cold heat of the cooling refrigerant flowing in the cooling refrigerant flow path (61a) is insulated by the thermal insulation layer (68). Thus, the cold heat of the cooling refrigerant can be more reliably prevented from being transferred to the outside from the non-contact surface (60b) of the cooling member (60). Moreover, since the cold heat of the cooling refrigerant is not transferred to the high temperature refrigerant flow path (61b), all the heat of the high temperature refrigerant in the high temperature refrigerant flow path (61b) is used to heat a region near the non-contact surface (60b), whereby the region near the non-contact surface (60b) has a high temperature. This suppresses occurrence of dew condensation around the cooling member (60).

According to a fifth invention, in the fourth invention, the thermal insulation layer (68) is formed by a vacuum layer or an air layer.

In the fifth invention, the thermal insulation layer (68) can be easily formed by the vacuum layer or the air layer.

According to a sixth invention, in any one of the first to fifth inventions, a decompression mechanism (81), which decompresses the refrigerant of the refrigerant circuit (20) and generates the cooling refrigerant, is provided in the cooling member (60).

In the sixth invention, the decompression mechanism (81) that generates the cooling refrigerant having a low temperature is provided in the cooling member (60). Thus, the high temperature refrigerant supplied to a refrigerant inlet of the cooling member (60) is decompressed by the decompression mechanism (81) in the cooling member (60) into the cooling refrigerant having a low temperature. Thus, the high temperature refrigerant flows into the refrigerant inlet of the cooling member (60), whereby occurrence of dew condensation around the refrigerant inlet of the cooling member (60) is suppressed.

According to a seventh invention, in the sixth invention, the cooling member (60) is configured so that the cooling refrigerant, which has cooled the power module (56), exchanges heat with the refrigerant located upstream of the decompression mechanism (81) in the cooling member (60).

In the seventh invention, the cooling refrigerant that has cooled the power module (56) is heated by exchanging heat with the high temperature refrigerant located upstream of the decompression mechanism (81) in the cooling member (60), whereby the refrigerant flowing out of the cooling member (60) has an increased temperature. Thus, the refrigerant heated by the high temperature refrigerant flows in a refrigerant outlet of the cooling member (60). This suppresses occurrence of dew condensation around the refrigerant outlet of the cooling member (60).

According to an eighth invention, in the sixth invention, a thermal insulation pipe (85) is connected to the refrigerant outlet of the cooling member (60).

In the eighth invention, the cooling refrigerant, which has cooled the power module (56) in the cooling member (60), flows into the thermal insulation pipe (85) through the refrigerant outlet of the cooling member (60). In the thermal insulation pipe, the cold heat of the cooling refrigerant is not transferred to the outside. This suppresses occurrence of dew condensation near the refrigerant outlet of the cooling member (60).

According to a ninth invention, in any one of the first to eighth inventions, the preventing unit is configured to prevent the cold heat of the refrigerant flowing in the cooling member (60) from being transferred to the outside from an outer edge of the contact surface (60a) of the cooling member (60) with the power module (56).

Typically, the outer edge of the power module (56) is separated from a heat generating portion that generates heat when a current is applied thereto. Thus, cooling the outer edge of the power module (56) does not contribute to cooling of the heat generating portion. Moreover, cooling the outer edge of the power module (56) may cause dew condensation around the outer edge of the power module (56) because the temperature of the outer edge of the power module (56) may become lower than the ambient air temperature.

In the ninth invention, even when the refrigerant flows in the cooling member (60) to cool the power module (56), the preventing unit does not allow the cold heat of the refrigerant from being transferred to the outside from the outer edge of the contact surface (60a) of the cooling member (60) with the power module (56). Moreover, the heat generated by the heat generating portion of the power module (56) suppresses a temperature drop. This suppresses cooling of air around the outer edge of the contact surface of the power module (56) with the cooling member (60). Thus, no dew condensation occurs around the cooling member (60), and the possibility is reduced that water droplets formed by dew condensation flow toward the electronic part (56, 57, 59).

According to a tenth invention, in the ninth invention, the preventing unit is configured so that a heat transfer surface, which transfers the cold heat of the refrigerant flowing in the cooling member (60) to the power module (56), has a smaller area than a surface of the power module (56), which corresponds to the cooling member (60).

In the tenth invention, the portion to which the cold heat of the refrigerant flowing in the cooling member (60) is transferred is smaller than the power module (56). Thus, the heat generating portion of the power module (56), which needs to be cooled, is intensively cooled, and a region that is located away from the heat generating portion and does not need to be cooled is not cooled.

According to an eleventh invention, in any one of the first to tenth inventions, a non-contact surface, which is a surface of the power module (56) other than a contact surface with the cooling member (60), is covered by a thermal insulation layer (66).

In the eleventh invention, the non-contact surface of the power module (56) is covered by the thermal insulation layer (66). This suppresses cooling of air around the power module (56) even when the power module (56) is strongly cooled by the refrigerant flowing in the cooling member (60). Thus, occurrence of dew condensation on the surface of the power module (56) is suppressed.

According to a twelfth invention, in the second or fourth invention, the thermal insulation layer (65, 68) is comprised of an insert-molded insulating resin.

In the twelfth invention, the thermal insulation layer (65, 68) is comprised of the insert-molded insulating resin. With this configuration, the thermal insulation layer (65, 68) having high thermal insulation performance is easily formed by insert molding.

According to a thirteenth invention, in any one of the second, fourth, and eleventh inventions, the thermal insulation layer (65, 66, 68) is formed by spraying urethane.

In the thirteenth invention, the thermal insulation layer (65, 66, 68) is formed by spraying urethane. With this configuration, the thermal insulation layer (65, 66, 68) having high thermal insulation performance is easily formed by merely spraying urethane.

### ADVANTAGES OF THE INVENTION

According to the present invention, the preventing unit prevents the cold heat of the refrigerant from being transferred to the outside from the non-contact surface (60b) other than the contact surface (60a) of the cooling member (60) with the power module (56) when cooling the power module (56) by the refrigerant flowing in the cooling member (60). This can prevent the air around the cooling member (60) from being cooled by the cold heat of the refrigerant flowing in the cooling member (60). Thus, no dew condensation occurs around the cooling member (60), and the possibility is reduced that water droplets formed by dew condensation may flow toward the electronic part (56, 57, 59). Accordingly, failure of the electronic part (56, 57, 59) can be avoided.

According to the second invention, the preventing unit that prevents the cold heat of the refrigerant flowing in the cooling member (60) from being transferred to the outside from the non-contact surface (60b) other than the contact surface (60a) with the power module (56) can be easily formed by the thermal insulation layer (65).

According to the third to fifth inventions, the preventing unit that prevents the cold heat of the refrigerant flowing in the cooling member (60) from being transferred to the outside from the non-contact surface (60b) other than the contact surface (60a) with the power module (56) can be easily formed.

In particular, according to the fourth and fifth inventions, the cold heat of the cooling refrigerant flowing in the cooling refrigerant flow path (61a) is insulated by the thermal insulation layer (68). Thus, the cold heat of the cooling refrigerant can be more reliably prevented from being transferred to the outside from the non-contact surface (60b) of the cooling member (60). Moreover, since the cold heat of the cooling refrigerant is not transferred to the high temperature refrigerant flow path (61b), all the heat of the high temperature refrigerant in the high temperature refrigerant flow path (61b) is used to heat the region near the non-contact surface (60b), whereby the region near the non-contact surface (60b) can be maintained at a relatively high temperature. This can suppress occurrence of dew condensation around the cooling member (60), whereby failure of the power module (56) can be avoided.

According to the sixth invention, the decompression mechanism (81) that generates the cooling refrigerant having a low temperature is provided in the cooling member (60) so that the high temperature refrigerant flows near the refrigerant inlet of the cooling member (60). This can suppress occurrence of dew condensation near the refrigerant inlet of the cooling member (60), whereby failure of the power module (56) can be avoided.

According to the seventh invention, the cooling refrigerant that has cooled the power module (56) is caused to exchange heat with the high temperature refrigerant located upstream of the decompression mechanism (81) in the cooling member (60), thereby increasing the temperature of the refrigerant flowing out of the cooling member (60). This can suppress occurrence of dew condensation around the refrigerant outlet of the cooling member (60), whereby failure of the power module (56) can be avoided.

According to the eighth invention, occurrence of dew condensation near the refrigerant outlet of the cooling member (60) can be suppressed by a simple configuration.

According to the ninth invention, the preventing unit is configured so that the cold heat of the refrigerant is not transferred to the outside from the outer edge of the contact surface (60a) of the cooling member (60) with the power module (56). This can suppress cooling of the air around the outer edge of the contact surface of the power module (56) with the cooling member (60). Moreover, the heat generated in the heat generating portion of the power module (56) suppresses a temperature drop of the outer edge of the contact surface of the power module (56) with the cooling member (60). Thus, occurrence of dew condensation around the cooling member (60) is suppressed, whereby failure of the power module (56) can be avoided.

According to the tenth invention, the portion to which the cold heat of the refrigerant flowing in the cooling member (60) is transferred is smaller than the power module (56). Thus, the heat generating portion of the power module (56), which needs to be cooled, can be intensively cooled, and the region that is located away from the heat generating portion and does not need to be cooled is not cooled, whereby occurrence of dew condensation in this region can be avoided.

According to the eleventh invention, the non-contact surface, which is the surface of the power module (56) other than the contact surface with the cooling member (60), is covered by the thermal insulation layer (66). This suppresses cooling of the air around the power module (56) even when the power module (56) is strongly cooled by the refrigerant flowing in the cooling member (60). Thus, occurrence of dew condensation on the surface of the power module (56) can be suppressed, whereby failure of the power module (56) and other electronic parts (57, 59) can be avoided.

According to the twelfth invention, the thermal insulation layer (65, 68) having high thermal insulation performance can be easily formed by insert molding.

According to the thirteenth invention, the thermal insulation layer (65, 66, 68) having high thermal insulation performance can be easily formed by merely spraying urethane.

### BRIEF DESCRIPTION OF THE DRAWINGS

[FIG. 1] FIG. 1 is a refrigerant circuit diagram showing a schematic configuration of an air conditioner according to a first embodiment of the present invention.
[FIG. 2] FIG. 2 is a longitudinal cross-sectional view showing an internal structure of an inverter control board.
[FIG. 3] FIG. 3 is a perspective view showing a schematic configuration of a cooling member.
[FIG. 4] FIG. 4 is a longitudinal cross-sectional view showing an internal structure of an inverter control board of an air conditioner according to a second embodiment.
[FIG. 5] FIG. 5 is a longitudinal cross-sectional view showing an internal structure of an inverter control board of an air conditioner according to a third embodiment.
[FIG. 6] FIG. 6 is a longitudinal cross-sectional view showing a schematic configuration of the inside of a partition plate in FIG. 5.
[FIG. 7] FIG. 7 is an enlarged cross-sectional view showing a cooling member in FIG. 5.
[FIG. 8] FIGS. 8A-8B are diagrams each showing a temperature distribution obtained when cooling a power module by a cooling member according to the third embodiment, where FIG. 8A shows the case where a contact surface of a main body has a larger area than the power module, and FIG. 8B shows the case where the contact surface of the main body has a smaller area than the power module.
[FIG. 9] FIG. 9 is an enlarged cross-sectional view showing a cooling member according to a first modification of the third embodiment.
[FIG. 10] FIG. 10 is an enlarged plan view showing a power module and a contact surface of a main body of a cooling member according to a second modification of the third embodiment.
[FIG. 11] FIG. 11 is an enlarged cross-sectional view showing a cooling member according to a fourth embodiment.
[FIG. 12] FIG. 12 is an enlarged cross-sectional view showing a cooling member according to a fifth embodiment.
[FIG. 13] FIG. 13 is an enlarged cross-sectional view showing a cooling member according to a sixth embodiment.
[FIG. 14] FIG. 14 is an enlarged cross-sectional view showing a cooling member according to a modification of the sixth embodiment.

### DESCRIPTION OF EMBODIMENTS

Embodiments of the present invention will be described below with reference to the accompanying drawings. The following preferred embodiments are essentially described by way of illustration, and are in no way intended to limit the present invention and the uses or applications of the present invention.

### (First Embodiment)

### <Overall Configuration of Air Conditioner>

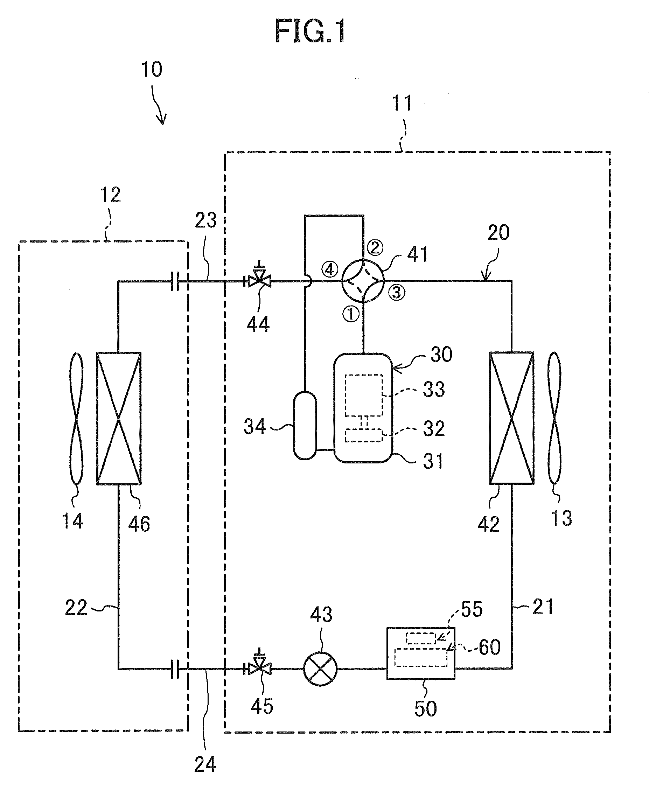

FIG. 1 is a refrigerant circuit diagram showing a schematic configuration of an air conditioner according to a first embodiment of the present invention. As shown in FIG. 1, this air conditioner (10) is formed by a refrigeration apparatus that performs a vapor compression refrigeration cycle. The air conditioner (10) includes one outdoor unit (11) that is installed outdoors, and one indoor unit (12) that is installed indoors. An outdoor circuit (21) is accommodated in the outdoor unit (11). An indoor circuit (22) is accommodated in the indoor unit (12). In this air conditioner (10), the outdoor circuit (21) is connected to the indoor circuit (22) by a pair of connecting pipes (23, 24) to form a refrigerant circuit (20).

The outdoor circuit (21) is provided with a compressor (30), a four-way switching valve (41), an outdoor heat exchanger (42), a cooling member (60), and an expansion valve (43). The cooling member (60) will be described later.

The compressor (30) has its discharge side connected to a first port of the four-way switching valve (41), and its suction side connected to a second port of the four-way switching valve (41) via an accumulator (34). The four-way switching valve (41) has its third port connected to one end of the outdoor heat exchanger (42), and its fourth port connected to a gas-side stop valve (44). The other end of the outdoor heat exchanger (42) is connected to one end of the expansion valve (43) via the cooling member (60). The other end of the expansion valve (43) is connected to a liquid-side stop valve (45).

The indoor circuit (22) is provided with an indoor heat exchanger (46). The indoor circuit (22) has its gas-side end connected to the gas-side stop valve (44) via the gas-side connecting pipe (23), and its liquid-side end connected to the liquid-side stop valve (45) via the liquid-side connecting pipe (24).

The compressor (30) is a so-called hermetic compressor. That is, in the compressor (30), a compression mechanism (32) configured to compress a refrigerant and an electric motor (33) configured to rotationally drive the compression mechanism (32) are accommodated in a single casing (31). The four-way switching valve (41) is switched between a first state (the state shown by solid line in FIG. 1) where the first port communicates with the third port and the second port communicates with the fourth port, and a second state (the state shown by broken line in FIG. 1) where the first port communicates with the fourth port and the second port communicates with the third port. The expansion valve (43) is an electric expansion valve whose valve body is driven by a pulse motor and whose degree of opening can be varied.

Each of the outdoor heat exchanger (42) and the indoor heat exchanger (46) is a fin-and-tube heat exchanger configured to cause the refrigerant to exchange heat with air. The outdoor heat exchanger (42) causes the refrigerant to exchange heat with outdoor air. The outdoor unit (11) is provided with an outdoor fan (13) configured to blow outdoor air to the outdoor heat exchanger (42). The indoor heat exchanger (46) causes the refrigerant to exchange heat with indoor air. The indoor unit (12) is provided with an indoor fan (14) configured to blow indoor air to the indoor heat exchanger (46).

The air conditioner (10) has a box-shaped inverter control board (50), and an inverter device (55) accommodated in the inverter control board (50). The inverter device (55) forms a power supply circuit of the compressor (30). Specifically, the inverter device (55) forms a power supply circuit configured to convert the frequency of an alternating current supplied from a commercial power source to a command value from a controller (not shown), and to supply the alternating current having the converted frequency to the electric motor (33) of the compressor (30).

### <Internal Structure of Inverter Control Board>

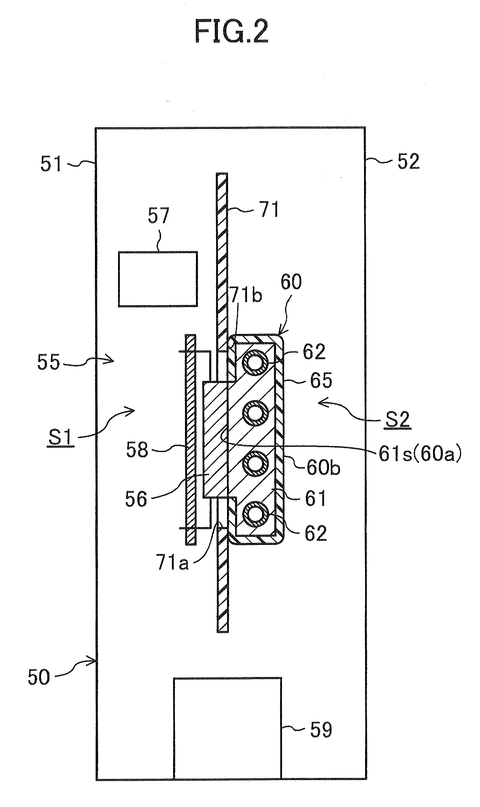

Next, an internal structure of the inverter control board (50) will be described in detail with reference to FIG. 2. The inverter control board (50) is formed by a housing in the shape of a vertically long rectangular parallelepiped. A door (51) capable of being opened and closed is formed on the front side (the left side in FIG. 2) of the inverter control board (50), and a mounting plate (52) is formed on the back side (the right side in FIG. 2) of the inverter control board (50).

The inverter device (55) and the cooling member (60) described above are accommodated in the inverter control board (50).

The inverter device (55) is formed by a plurality of electronic parts. Specifically, in the first embodiment, a power module (56), a capacitor (57), and a reactor (59) are provided as the electronic parts. The power module (56) is formed by an insulated gate bipolar transistor (IGBT) module including an IGBT chip that generates heat during operation. The power module (56) is mounted on a wiring substrate (58). The capacitor (57) is provided in an upper part of a first space (S1) described below. The reactor (59) is installed on the bottom of the inverter control board (50).

The cooling member (60) includes a main body (61) and a refrigerant pipe (62). The main body (61) is comprised of a metal material having high thermal conductivity, such as aluminum. The main body (61) has a base portion in the shape of a rectangular parallelepiped that is flat in the longitudinal direction, and a raised portion that is slightly raised from the base portion. The main body (61) is provided so that an end face of the raised portion contacts the power modules (56), in order to allow the main body (61) to exchange heat with the power module (56) via the raised portion. The end face of the raised portion forms a contact surface (61s) with the power module (56), out of the surface of the main body (61) according to the present invention. In the first embodiment, the end face of the raised portion also forms a contact surface (60a) of the cooling member (60) with the power module (56).

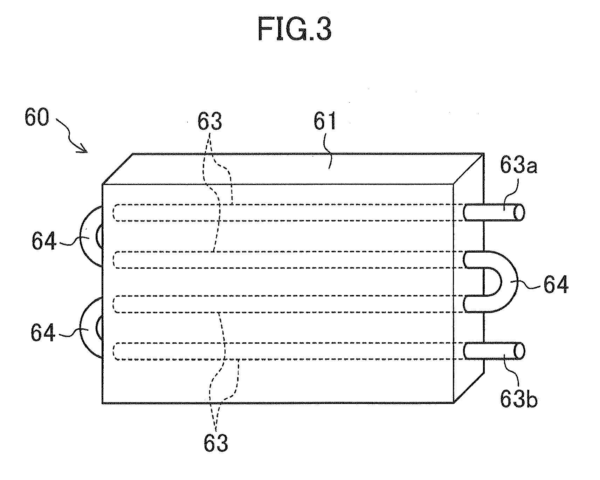

The refrigerant pipe (62) is embedded in the main body (61) to form a refrigerant flow path through which the refrigerant flows. The refrigerant pipe (62) is comprised of a metal material having high thermal conductivity, such as copper. As shown in FIG. 3, the refrigerant pipe (62) has four straight pipe portions (63) and three U-shaped pipe portions (64) configured to connect the straight pipe portions (63) in series. The number of straight pipe portions (63) and the number of U-shaped pipe portions (64) are shown by way of example, and may be more or less than the above values. The straight pipe portions (63) extend through the main body (61) so as to be parallel to the front and back surfaces of the main body (61). The U-shaped pipe portions (64) are located at both longitudinal ends of the main body (61), and each U-shaped pipe portion (64) connects corresponding vertically adjoining two of the straight pipe portions (63) together. One of an end (63a) of the uppermost one of the plurality of straight pipe portions (63) and an end (63b) of the lowermost one (63) forms a refrigerant inlet portion, and the other forms a refrigerant outlet portion.

As shown in FIG. 2, the cooling member (60) includes a thermal insulation layer (65) formed on the surface of the main body (61). The thermal insulation layer (65) is formed by, e.g., insert molding an insulating resin around the main body (61), and covers the surface of the main body (61) except the contact surface (61s) between the main body (61) and the power module (56). That is, the thermal insulation layer (65) covers a non-contact surface of the main body (61), namely the surface of the main body (61) other than the contact surface (61s) with the power module (56).

The thermal insulation layer (65) may be formed by spraying urethane on the surface of the main body (61). Alternatively, the thermal insulation layer (65) may be formed by using a hollow thermal insulation material.

This configuration can prevent cold heat of the refrigerant flowing in the cooling member (60) from being transferred to the outside from a non-contact surface (60b) other than the contact surface (60a) of the cooling member (60) with the power module (56) (in the first embodiment, the contact surface (61 s) of the main body (61) with the power module (56)) when cooling the power module (56) by the refrigerant flowing in the cooling member (60). That is, the thermal insulation layer (65) forms the preventing unit according to the present invention, and can prevent air around the cooling member (60) from being cooled. Thus, no dew condensation occurs around the cooling member (60), and the possibility is reduced that water droplets formed by dew condensation may flow toward the electronic parts (56, 57, 59). Accordingly, failure of the electronic parts (56, 57, 59) can be avoided.

The internal space of the inverter control board (50) is roughly divided into two spaces (the first space (S1) and a second space (S2)) by a partition plate (71). The partition plate (71) is formed in the shape of a flat plate extending in the vertical direction, and is comprised of an insulating synthetic resin having low thermal conductivity. A rectangular opening (71a) is formed substantially in the center of the partition plate (71) so as to extend therethrough in the thickness direction.

The opening (71a) of the partition plate (71) is closed by the cooling member (60). Specifically, the opening (71a) is formed so that both vertical and horizontal dimensions thereof are smaller than those of the cooling member (60). The cooling member (60) is supported by an outer periphery (71b) of the opening (71 a) in one of both end faces in the thickness direction of the partition plate (71), namely the end face located on the side of the mounting plate (52). The cooling member (60) thus covers the entire opening (71a) from the side of the second space (S2).

In the first space (S1), the power module (56) is fixed to the cooling member (60) so as to contact the front surface (the end face of the raised portion) of the main body (61). The capacitor (57) is placed in the upper part of the first space (S1).

In this manner, the power module (56) is in contact with the main body (61) of the cooling member (60) so that heat can be exchanged between the refrigerant flowing in the refrigerant pipe (62) and the power module (56). In other words, the main body (61) is in contact with the power module (56) so that the power module (56) is cooled by the refrigerant flowing in the main body (61). Thus, the cooling member (60) is configured to cool the power module (56) by the refrigerant.

### Operation

Operation of the air conditioner (10) of the first embodiment will be described below. The air conditioner (10) of the first embodiment selectively performs a cooling operation and a heating operation.

### <Cooling Operation>

First, the cooling operation will be described. During the cooling operation, in the air conditioner (10), the four-way switching valve (41) is switched to the first state (the state shown by solid line in FIG. 1), and the outdoor fan (13) and the indoor fan (14) are operated. During the cooling operation, a refrigeration cycle is performed in the refrigerant circuit (20) so that the outdoor heat exchanger (42) serves as a condenser and the indoor heat exchanger (46) serves as an evaporator.

During the cooling operation, in the refrigerant circuit (20), the refrigerant discharged from the compressor (30) flows into the outdoor heat exchanger (42) through the four-way switching valve (41), and dissipates heat to the outdoor air and condenses. The refrigerant that has condensed in the outdoor heat exchanger (42) flows into the refrigerant pipe (62) of the cooling member (60).

Heat is generated in the power module (56) when a current is applied thereto. Since the refrigerant that has condensed in the outdoor heat exchanger (42) is flowing in the refrigerant pipe (62) of the cooling member (60), the heat generated in the power module (56) is sequentially conducted to the main body (61) and the refrigerant pipe (62), and is transferred to the refrigerant flowing in the refrigerant pipe (62). This suppresses an increase in temperature of the power module (56).

The refrigerant that has flown out of the refrigerant pipe (62) of the cooling member (60) is decompressed when flowing through the expansion valve (43), and then flows into the indoor heat exchanger (46). In the indoor heat exchanger (46), the refrigerant absorbs heat from the indoor air and evaporates, whereby the indoor air is cooled. The refrigerant that has evaporated in the indoor heat exchanger (46) sequentially flows through the four-way switching valve (41) and the accumulator (34), and then is sucked into the compressor (30) and compressed therein.

### <Heating operation>

Next, the heating operation will be described. During the heating operation, in the air conditioner (10), the four-way switching valve (41) is switched to the second state (the state shown by broken line in FIG. 1), and the outdoor fan (13) and the indoor fan (14) are operated. During the heating operation, a refrigeration cycle is performed in the refrigerant circuit (20) so that the indoor heat exchanger (46) serves as a condenser and the outdoor heat exchanger (42) serves as an evaporator. During the heat operation, the cooling member (60) is located between the expansion valve (43) and the outdoor heat exchanger (42) as the evaporator in the refrigerant circuit (20).

During the heating operation, in the refrigerant circuit (20), the refrigerant discharged from the compressor (30) flows into the indoor heat exchanger (46) through the four-way switching valve (41). In the indoor heat exchanger (46), the refrigerant dissipates heat to the indoor air and condenses. As a result, the indoor air is heated. The refrigerant that has condensed in the indoor heat exchanger (46) is decompressed when flowing through the expansion valve (43), and then flows into the refrigerant pipe (62) of the cooling member (60).

Heat is generated in the power module (56) when a current is applied thereto. Since the refrigerant that has been decompressed by the expansion valve (43) is flowing in the refrigerant pipe (62) of the cooling member (60), the heat generated in the power module (56) is sequentially conducted to the main body (61) and the refrigerant pipe (62), and is transferred to the refrigerant flowing in the refrigerant pipe (62). This suppresses an increase in temperature of the power module (56).

The refrigerant that has flown out of the refrigerant pipe (62) of the cooling member (60) flows into the outdoor heat exchanger (42), and absorbs heat from the outdoor air and evaporates. The refrigerant that has evaporated in the outdoor heat exchanger (42) sequentially flows through the four-way switching valve (41) and the accumulator (34), and then is sucked into the compressor (30) and compressed therein.

### Advantages of First Embodiment

As described above, in the air conditioner (10) according to the first embodiment, the thermal insulation layer (65) prevents the cold heat of the refrigerant from being transferred to the outside from the non-contact surface (60b) other than the contact surface (60a) of the cooling member (60) with the power module (56) when cooling the power module (56) by the refrigerant flowing in the cooling member (60). Thus, the air around the cooling member (60) can be prevented from being cooled by the cold heat of the refrigerant flowing in the cooling member (60). Thus, no dew condensation occurs around the cooling member (60), and the possibility is reduced that water droplets formed by dew condensation may flow toward the electronic parts (56, 57, 59). Accordingly, failure of the electronic parts (56, 57, 59) can be avoided, and reliability of the air conditioner (10) can be ensured. Specifically, if the cooling member (60) does not have the thermal insulation layer (65), air around the cooling member (60) is rapidly cooled when the refrigerant starts flowing in the refrigerant pipe (62) of the cooling member (60) during the above operation of the air conditioner (10). Thus, water vapor in the air may condense into water droplets. Such water droplets may lead to failure of the electronic parts such as the power module (56) and the capacitor (57) when they contact these electronic parts.

In the present invention, when the refrigerant flows in the refrigerant pipe (62) of the cooling member (60), the power module (56) is cooled by this refrigerant, and the thermal insulation layer (65) suppresses transfer of the cold heat of the refrigerant flowing in the cooling member (60), from the cooling member (60) to a region around the cooling member (60). This reduces the possibility that the air around the cooling member (60) may be cooled, whereby no dew condensation occurs around the cooling member (60). Accordingly, the possibility is reduced that water droplets may be formed by dew condensation in the second space (S2) and may flow toward the electronic parts (56, 57) in the first space (S1), or that the water droplets may fall downward from the surface of the cooling member (80). Thus, failure of the electronic parts (56, 57, 59) due to contact of the water can be avoided.

According to the first embodiment, the preventing unit of the present invention, which prevents the cold heat of the refrigerant flowing in the cooling member (60) from being transferred to the outside from the non-contact surface (60b) other than the contact surface (60a) of the cooling member (60) with the power module (56), can be easily formed by the thermal insulation layer (65) that covers the non-contact surface of the main body (61), namely the surface of the main body (61) other than the contact surface (61s) with the power module (56). That is, with a simple configuration, the air around the cooling member (60) can be prevented from being cooled by the cold heat of the refrigerant flowing in the cooling member (60).

### (Second Embodiment)

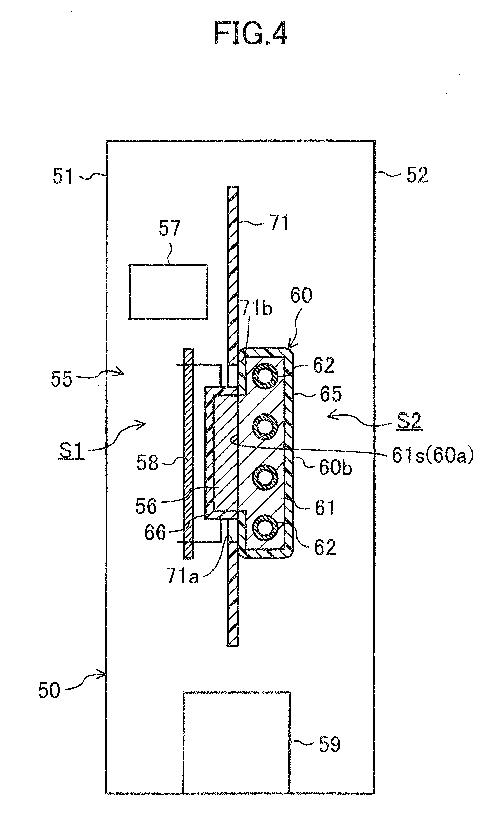

As shown in FIG. 4, the internal structure of the inverter control board (50) of the first embodiment is partially changed in a second embodiment.

Specifically, in the second embodiment, a thermal insulation layer (66) is also formed on the surface of the power module (56). More specifically, the thermal insulation layer (66) is formed on a non-contact surface of the power module (56), namely the surface of the power module (56) other than a contact surface with the cooling member (60). Like the thermal insulation layer (65) that covers the non-contact surface of the main body (61), the thermal insulation layer (66) is formed by insert molding an insulating resin.

With this configuration, the thermal insulation layer (66) suppresses cooling of air around the power module (56) even when the refrigerant flowing in the main body (61) of the cooling member (60) has a low temperature and the power module (56) is strongly cooled by the refrigerant as in, e.g., the heating operation. This can suppress occurrence of dew condensation on the surface of the power module (56), whereby failure of the power module (56) and other electronic parts (57, 59) can be avoided.

With this configuration, the main body (61) and the power module (56) are entirely covered by a thermal insulation material. That is, with the power module (56) being mounted on the main body (61), the main body (61) and the power module (56) are entirely covered by the thermal insulation layer (65, 66), and have no exposed portion. This can reliably suppress occurrence of dew condensation around the main body (61) and the power module (56), whereby failure of the power module (56) and other electronic parts (57, 59) can be avoided.

The thermal insulation layer (66) may be formed by spraying urethane etc. to the surface of a case of the power module (56).

### (Third Embodiment)

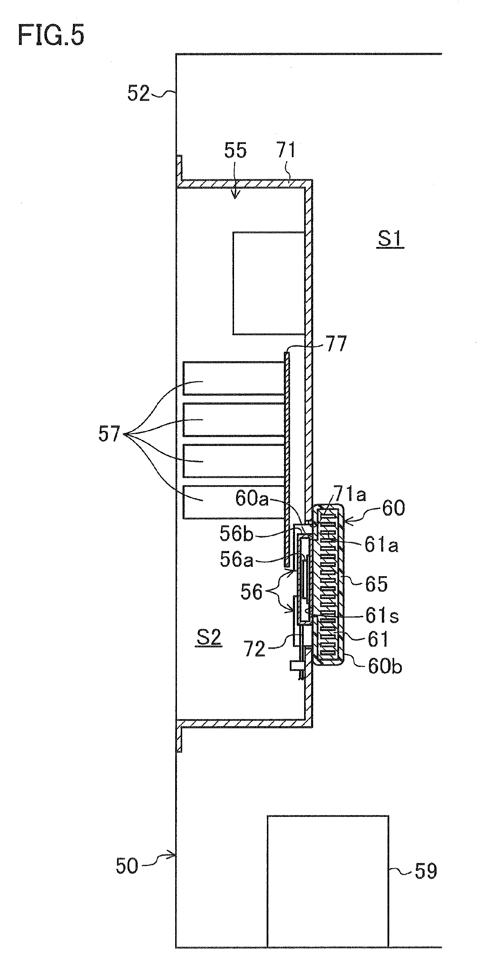

As shown in FIGS. 5-6, a third embodiment is intended for a large-sized air conditioner for use in large-scale facilities such as a factory. In the third embodiment, the internal structure of the inverter control board (50) is partially different from that in the first embodiment.

Specifically, the inverter control board (50) is formed in the shape of a rectangular parallelepiped with a depth of 30 inches and a height of about 90 inches. The door (51) capable of being opened and closed is provided on the back side (the right side in FIG. 5) of the inverter control board (50), and the mounting plate (52) is provided on the front side (the left side in FIG. 5) of the inverter control board (50). Although not shown in the figures, the inverter control board (50) is provided with an inlet port and an outlet port of outside air, and a fan that produces an air flow from the inlet port to the outlet port in the internal space of the inverter control board (50) to provide ventilation.

In the third embodiment, the partition plate (71) is formed in the shape of a box that opens in one surface, and is attached to the mounting plate (52) so that the open surface of the partition plate (71) is closed by the mounting plate (52). This partition plate (71) divides the internal space of the inverter control board (50) into two spaces (the first space (S1) and the second space (S2)), and the second space (S2) formed between the partition plate (71) and the mounting plate (52) is a closed space. The inverter device (55) is placed in the second space (S2). In the third embodiment, the reactor (59) is installed on the bottom of the first space (S1).

The rectangular opening (71a) is formed in a lower part of the back surface (the right end face in FIG. 5) of the partition plate (71). In the third embodiment, the cooling member (60) is attached to the back surface of the partition plate (71) so as to cover the opening (71a).

In the third embodiment, the inverter device (55) is formed by connecting a plurality of electronic parts by bar-shaped or plate-shaped bus bars (72) comprised of a conductive metal. Specifically, the inverter device (55) includes a rectifier circuit connected to a commercial power source, a capacitor circuit, and an inverter circuit. Each of the rectifier circuit and the inverter circuit is formed by connecting a plurality of power modules (56) by the bus bars (72). Each power module (56) includes a power semiconductor chip (56a) that generates heat when operated, and a case (56b) that accommodates the power semiconductor chip (56a). Specifically, each power module (56) provided in the rectifying circuit is a diode module including a diode chip, and each power module (56) provided in the inverter circuit is an IGBT module including an IGBT chip. The capacitor (57) is connected to the capacitor circuit.

The capacitor (57) is fixed to a plate-like mounting member (77) fixed to the partition plate (71). Electronic parts other than the capacitor (57) and the power module (56) are fixed to the partition plate (71) or the mounting member (77).

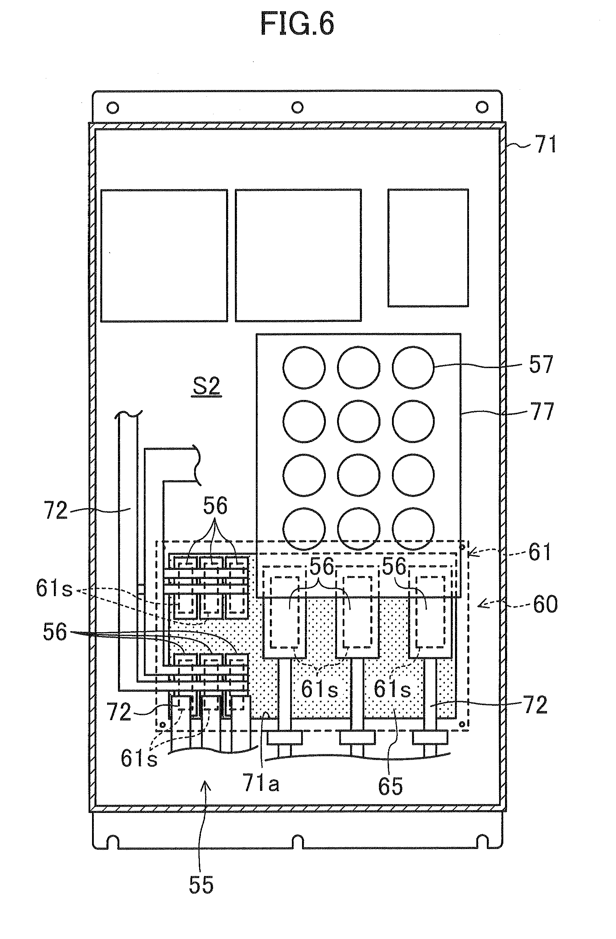

As shown in FIG. 6, the plurality of power modules (56) are fixed to the cooling member (60) attached to the back surface of the partition plate (71). Specifically, each power module (56) is fixed to the cooling member (60) so as to contact, in the opening (71a) of the partition plate (71), the front surface of the cooling member (60) that covers the opening (71 a).

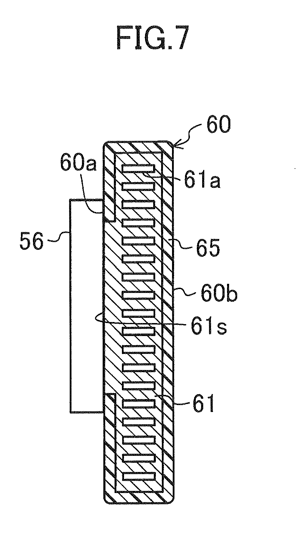

In the third embodiment, as shown in the expanded view of FIG. 7, the cooling member (60) does not have the refrigerant pipe (62) embedded in the main body (61) as in the first or second embodiment, and a refrigerant flow path (61a) in which the refrigerant flows is formed by forming a hole in the main body (61).

In the third embodiment as well, the cooling member (60) includes the thermal insulation layer (65) formed on the surface of the main body (61). The thermal insulation layer (65) covers the non-contact surface of the main body (61), namely the surface of the main body (61) except the contact surfaces (61s) between the main body (61) and the power modules (56). With this configuration, only the contact surfaces (61s) of the main body (61) serve as a heat transfer surface that transfers the cold heat of the refrigerant flowing in the cooling member (60) to the power modules (56).

In the third embodiment, the main body (61) of the cooling member (60) has raised portions corresponding to the number of power modules (56), and contacts, at an end face of each raised portion, each power module (56). That is, the end face of each raised portion serves as the contact surface (61 s) of the main body (61) with a corresponding one of the power modules (56).

In the third embodiment, the main body (61) of the cooling member (60) is configured so that each contact surface (61s) contacts a part of the back surface (the surface on the side of the cooling member (60)) of the case (56b) of a corresponding one of the power modules (56), namely a central portion of the back surface of the case (56b) having on its inner surface the power semiconductor chip (56a) that generates heat when a current is applied thereto. In other words, the main body (61) is formed so that each contact surface (61 s) between the main body (61) and the power module (56) has a smaller area than the back surface (the surface corresponding to the cooling member (60)) of the case (56b) of the power module (56). Thus, the outer edge of the contact surface of each power module (56) with the main body (61) contacts the thermal insulation layer (65) rather than the main body (61). That is, a part of the thermal insulation layer (65) is interposed between the main body (61) and each power module (56) to form a part of the contact surface (60a) of the cooling member (60) with the power module (56).

With this configuration, heat of the power semiconductor chip (56a) of each power module (56) is transferred to the main body (61) of the cooling member (60) via a corresponding one of the contact surfaces (61s), and is dissipated to the refrigerant flowing in the refrigerant flow path (61a). In other words, when the refrigerant having a low temperature flows into the refrigerant flow path (61 a) of the main body (61), the cold heat of the refrigerant is transferred to the power modules (56) via the contact surfaces (61 s) as the heat transfer surface. Thus, a part of each power module (56) where the temperature increases particularly, namely the power semiconductor chip (56a), is cooled by the refrigerant flowing in the cooling member (60).

On the other hand, the thermal insulation layer (65) prevents the cold heat of the refrigerant flowing in the cooling member (60) (the refrigerant in the refrigerant flow path (61 a)) from being transferred to the outside from any region other than the contact surfaces (61s) with the power modules (56). This prevents air around the cooling member (60) from being cooled by the cold heat of the refrigerant flowing in the cooling member (60). As a result, no dew condensation occurs around the cooling member (60), and the possibility is reduced that water droplets formed by dew condensation may flow toward the electronic parts (56, 57, 59). Accordingly, failure of the electronic parts (56, 57, 59) can be avoided, and reliability of the air conditioner (10) can be ensured.

Typically, the outer edge of the power module (56) is separated from the power semiconductor chip (56a) as a heat generating portion that generates heat when a current is applied thereto. Thus, cooling the outer edge of the power module (56) does not contribute to cooling of the power semiconductor chip (56a) as the heat generating portion. Moreover, cooling the outer edge of the power module (56) may cause dew condensation around the outer edge of the power module (56) because the temperature of the outer edge of the power module (56) may become lower than the ambient air temperature.

In the third embodiment, as described above, the main body (61) is formed so that each of the contact surfaces (61s) (the heat transfer surface) with the power modules (56) has a smaller area than the back surface (the surface corresponding to the cooling member (60)) of the case (56b) of the power module (56). Thus, in the present embodiment, the outer edge of the contact surface of the power module (56) with the main body (61) contacts the thermal insulation layer (65) rather than the main body (61). As a result, in each power module (56), a portion around the power semiconductor chip (56a) that generates heat when a current is applied thereto and thus needs to be cooled is intensively cooled. On the other hand, a part of the thermal insulation layer (65) contacts the outer edge of the power module (56) which does not need to be cooled, and thus the cold heat of the refrigerant flowing in the refrigerant flow path (61a) is not transferred to the outer edge of the power module (56). That is, the outer edge of the power module (56) is not cooled. This can suppress occurrence of dew condensation on the outer edge of the power module (56), which is separated from the power semiconductor chip (56a) as the heat generating portion. Accordingly, failure of the power module (56) can be avoided.

That is, since the contact surface (61 s) of the main body (61) is configured to be smaller than the surface of the power module (56) which corresponds to the main body (61), the heat generating portion of the power module (56) is cooled, and a temperature drop due to cooling of the outer edge of the power module (56) which does not need to be cooled is avoided, whereby occurrence of dew condensation can be avoided. This point was verified by simulation, and the result is shown below.

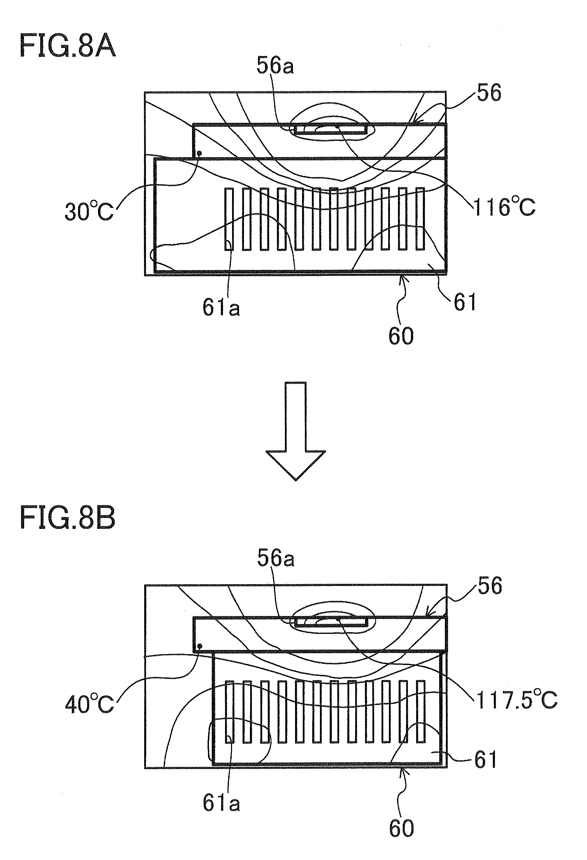

FIGS. 8A-8B show temperature distributions obtained by cooling the power module (56) with the cooling member (60) by simulation. FIG. 8A shows the case where the contact surface (61s) of the main body (61) has a larger area than the surface of the power module (56) which corresponds to the main body (61). FIG. 8B shows the case where the contact surface (61 s) of the main body (61) has a smaller area than the surface of the power module (56) which corresponds to the main body (61). Thin lines in the figures represent isothermal lines. Although not shown in the figures, in each case, the non-contact surface of the main body (61), namely the surface of the main body (61) other than the contact surface (61s), is covered by the thermal insulation layer (65).

Simulation calculation was performed on the cooling members (60) of the above two cases at a refrigerant temperature of 5°C and an ambient temperature of 52°C. As shown in FIG. 8A, in the case where the contact surface (61s) has a larger area than the surface of the power module (56) which corresponds to the main body (61) (hereinafter referred to as the "case of the large contact surface"), the temperature of the outer edge of the power module (56) dropped to 30°C. On the other hand, as shown in FIG. 8B, in the case where the contact surface (61s) has a smaller area than the surface of the power module (56) which corresponds to the main body (61) (hereinafter referred to as the "case of the small contact surface"), the temperature of the outer edge of the power module (56) dropped only to 40°C. On the other hand, the temperature of the power semiconductor chip (56a) as the heat generating portion of the power module (56) was 116°C in the case of the large contact surface shown in FIG. 8A, and was 117.5°C in the case of the small contact surface shown in FIG. 8B. Thus, the temperature of the power semiconductor chip (56a) was substantially about the same in both cases. This shows that making the contact surface (61s) of the main body (61) smaller than the surface of the power module (56) which corresponds to the main body (61) suppresses a temperature drop due to cooling of the outer edge of the power module (56) which does not need to be cooled.

Thus, as in the third embodiment, since the contact surface (61s) of the main body (61) is configured to have a smaller area than the surface of the power module (56) which corresponds to the main body (61), the heat generating portion of the power module (56), which needs to be cooled, can be intensively cooled. At the same time, the portion that is located away from the heat generating portion and does not need to be cooled is not cooled, whereby occurrence of dew condensation on this portion can be avoided.

### First Modification of Third Embodiment

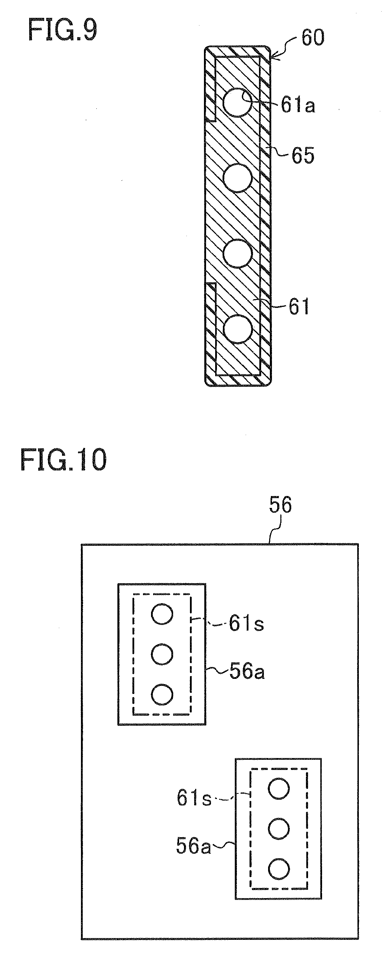

As shown in FIG. 9, the shape of the refrigerant flow path (61a) of the main body (61) of the cooling member (60) is changed in a first modification. In the first modification, the refrigerant flow path (61a) in which the refrigerant flows is formed by forming a round hole in the main body (61) comprised of copper having high thermal conductivity.

### Second Modification of Third Embodiment

As shown in FIG. 10, in a second modification, in the case where each power module (56) contains a plurality of power semiconductor chips (56a), the main body (61) of the cooling member (60) may be configured to have raised portions corresponding to the number of power semiconductor chips (56a), and each power module (56) may be attached to the main body (61) of the cooling member (60) so that the power semiconductor chips (56a) respectively correspond to the end faces of the raised portions with the case (56b) interposed therebetween. That is, the main body (61) may have a plurality of contact surfaces (61 s) for each power module (56). By forming the main body (61) in this manner, only the heat generating portion that needs to be cooled can be cooled, whereby occurrence of dew condensation around the portion that does not need to be cooled can further be suppressed.

### (Fourth Embodiment)

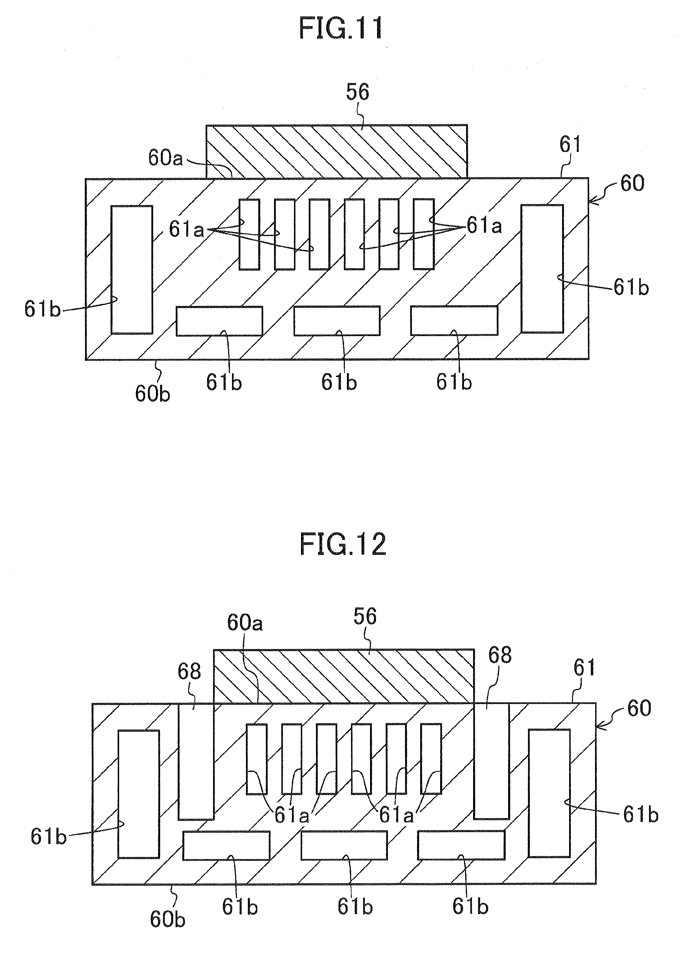

As shown in FIG. 11, the internal structure of the cooling member (60) of the first embodiment is changed in a fourth embodiment.

In the fourth embodiment, the cooling member (60) includes only the main body (61) comprised of a metal material having high thermal conductivity, such as aluminum. As in the third embodiment, refrigerant flow paths (61 a) in which the cooling refrigerant flows are formed by forming a plurality of holes in the main body (61). The plurality of refrigerant flow paths (61a) are arranged near the contact surface (60a) of the cooling member (60) with the power module (56).

In the fourth embodiment, a plurality of high temperature refrigerant flow paths (61b) in which a refrigerant having a high temperature flows are formed in a portion of the main body (61), which is located on the side of the non-contact surface (60b) of the cooling member (60) with the power module (56) with respect to the refrigerant flow paths (61a). The plurality of high temperature refrigerant flow paths (61b) are arranged so as to surround the refrigerant flow paths (61 a).

In the fourth embodiment, when the refrigerant having a low temperature flows into the refrigerant flow paths (61 a), the cold heat of the refrigerant is transferred to the power module (56) via the contact surface (60a). This suppresses an increase in temperature of the power module (56) that generates heat when a current is applied thereto.

On the other hand, a portion of the cooling member (60), which is located on the side of the non-contact surface (60b) with respect to the refrigerant flow paths (61a), is heated by the high temperature refrigerant flowing in the high temperature refrigerant flow paths (61b). Thus, the cold heat of the low temperature refrigerant flowing in the refrigerant flow paths (61a) is absorbed by the high temperature refrigerant flowing in the high temperature refrigerant flow paths (61b) located on the side of the non-contact surface (60b) with respect to the refrigerant flow paths (61a), or by a high temperature portion surrounding the refrigerant flow paths (61a) and heated by the high temperature refrigerant. Moreover, the non-contact surface (60b) is heated to a high temperature by the heat of the high temperature refrigerant flowing in the high temperature refrigerant flow paths (61b). Thus, the high temperature refrigerant flow paths (61b) with the high temperature refrigerant flowing therein prevents the cold heat of the refrigerant in the refrigerant flow paths (61a) from being transferred to the outside from the non-contact surface (60b) other than the contact surface (60a) of the cooling member (60) with the power module (56). That is, in the fourth embodiment, the plurality of high temperature refrigerant flow paths (61b) form the preventing unit according to the present invention. This suppresses occurrence of dew condensation around the cooling member (60), and reduces the possibility that water droplets formed by dew condensation may flow toward the electronic parts (56, 57, 59). Accordingly, failure of electronic parts (56, 57, 59) can be avoided.

### (Fifth Embodiment)

As shown in FIG. 12, the internal structure of the main body (61) of the cooling member (60) of the fourth embodiment is partially changed in the fifth embodiment.

Specifically, a vacuum layer (68) is formed between the refrigerant flow path (61a) and the high temperature refrigerant flow path (61b). The vacuum layer (68) is formed so as to surround the outer edge of the power module (56).

With this configuration, the cold heat of the refrigerant flowing in the refrigerant flow paths (61a) is insulated by the thermal insulation layer (68). Thus, the cold heat of the refrigerant can be more reliably prevented from being transferred to the outside from the non-contact surface (60b) of the cooling member (60). Moreover, since the cold heat of the refrigerant in the refrigerant flow paths (61a) is not transferred to the high temperature refrigerant flow paths (61b), all the heat of the high temperature refrigerant in the high temperature refrigerant flow paths (61b) is used to heat a region near the non-contact surface (60b), whereby the region near the non-contact surface (60b) can be maintained at a relatively high temperature. That is, in the fifth embodiment, the vacuum layer (68) and the plurality of high temperature refrigerant flow paths (61b) form the preventing unit according to the present invention. This configuration suppresses occurrence of dew condensation around the cooling member (60), whereby failure of the power module (56) can be avoided.

### Modification of Fifth Embodiment

The thermal insulation layer formed by the vacuum layer (68) may be formed by an air layer. Alternatively, the space in which the vacuum layer (68) is formed in the fifth embodiment may be filled with a resin material, urethane, etc. to form the thermal insulation layer. The manner in which the vacuum layer (68) is placed is not limited to the above embodiment. For example, one of the high temperature refrigerant flow paths (61b) may be replaced with the vacuum layer (68).

### (Sixth Embodiment)

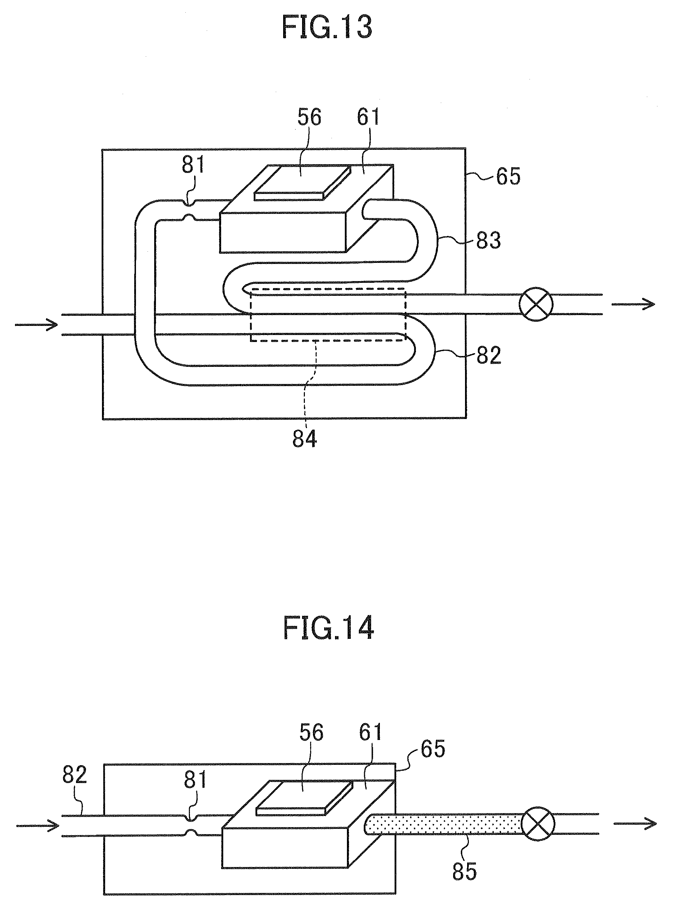

As shown in FIG. 13, the structure of the cooling member (60) of the first embodiment is changed in a sixth embodiment.

In the sixth embodiment, the cooling member (60) includes a main body (61) which is similar to that of the third embodiment and which is comprised of a metal material having high thermal conductivity such as aluminum, and a thermal insulation layer (65) that covers the non-contact surface other than the contact surface of the main body (61) with the power module (56). The thermal insulation layer (65) is formed by, e.g., insert molding an insulating resin around the main body (61).

A fixed throttle (81) as a decompression mechanism that decompresses a high temperature refrigerant of the refrigerant circuit (20) to produce a low temperature refrigerant for cooling is provided in the cooling member (60). Specifically, in the sixth embodiment, the fixed throttle (81) is provided in the thermal insulation layer (65). In the cooling member (60), an inlet-side pipe (82) contacts an outlet-side pipe (83) so as to allow heat to be exchanged therebetween, so that the refrigerant that has cooled the power module (56) exchanges heat with the refrigerant located upstream of the fixed throttle (81). That is, in the sixth embodiment, the fixed throttle (81) is formed in the inlet-side pipe (82) of the main body (61), and a portion of the inlet-side pipe (82), which is located upstream of the fixed throttle (81), is in contact with the outlet-side pipe (83) of the main body (61) so as to allow heat to be exchanged therebetween. In this state, the thermal insulation layer (65) is formed by insert molding a resin material so that the fixed throttle (81), a heat exchange portion (84) (the contact portion between the inlet-side pipe (82) and the outlet-side pipe (83)), and the non-contact surface other than the contact surface of the main body (61) with the power module (56) are covered by the resin material.

With this configuration, the fixed throttle (81) as the decompression mechanism that produces a low temperature refrigerant is provided in the cooling member (60) to allow a high temperature refrigerant to flow near a refrigerant inlet of the cooling member (60). This can suppress occurrence of dew condensation around the refrigerant inlet of the cooling member (60). Thus, failure of the power module (56) can be avoided.

According to the sixth embodiment, in the cooling member (60), the low temperature refrigerant that has cooled the power module (56) exchanges heat with the high temperature refrigerant located upstream of the fixed throttle (81), thereby increasing the temperature of the refrigerant flowing out of the cooling member (60). This can suppress occurrence of dew condensation around a refrigerant outlet of the cooling member (60), whereby failure of the power module (56) can be avoided.

### Modification of Sixth Embodiment

As shown in FIG. 14, in a modification of the sixth embodiment, the fixed throttle (81) is formed in the inlet-side pipe (82) of the main body (61). In this state, the thermal insulation layer (65) is formed by insert molding a resin material so that the fixed throttle (81) and the non-contact surface other than the contact surface of the main body (61) with the power module (56) are covered by the resin material. That is, unlike the sixth embodiment, the portion of the inlet-side pipe (82), which is located upstream of the fixed throttle (81), is not in contact with an outlet-side pipe of the main body (61) so as to allow heat to be exchanged therebetween. A thermal insulation pipe (85) is connected to a refrigerant outlet of the main body (61).

With this configuration, the cooling refrigerant that has cooled the power module (56) in the cooling member (60) flows into the thermal insulation pipe (85) through the refrigerant outlet of the cooling member (60). In the thermal insulation pipe, the cold heat of the cooling refrigerant is not transferred to the outside. This suppresses occurrence of dew condensation near the refrigerant outlet of the cooling member (60). Thus, in this modification as well, occurrence of dew condensation near the refrigerant inlet and outlet of the cooling member (60) can be suppressed by a simple configuration.

### (Other Embodiments)

In each of the above embodiments, the air conditioner (10) is used as a refrigeration apparatus that performs a refrigeration cycle. However, for example, a cooling apparatus that cools the inside of a heat pump chiller unit, a water heater, a refrigerator, or a freezer, etc. may be used as the refrigeration apparatus that performs a refrigeration cycle.

Each of the above embodiments is described with respect to the configuration capable of cooling only the power module (56, 56) of the present invention by the cooling member (60). However, for example, the capacitor (57) may be made to contact the front surface (the surface on the side of the first space (S1)) of the main body (61) of the cooling member (60) so that the capacitor (57) can be cooled by the cooling member (60).

Applications of the cooling member according to the present invention are not limited to cooling of the power module (56) of the compressor (30). For example, the cooling member of the present invention may be used to cool a power module of a central processing unit (CPU).

### INDUSTRIAL APPLICABILITY

As described above, the present invention is useful for refrigeration apparatuses that cool a power module by a cooling member.

### DESCRIPTION OF REFERENCE CHARACTERS

- 10: Air Conditioner (Refrigeration Apparatus)
- 20: Refrigerant Circuit
- 30: Compressor
- 50: Inverter Control Board
- 56: Power Module (Electronic Part, Power Module)
- 57: Capacitor (Electronic Part)
- 59: Reactor (Electronic Part)
- 60: Cooling Member
- 61: Main Body
- 62: Refrigerant Pipe
- 65: Thermal Insulation Layer
- 66: Thermal Insulation Layer

## Claims

1. A refrigeration apparatus, comprising:
a refrigerant circuit (20) to which a compressor (30) is connected, and which performs a refrigerating cycle;
an electronic part (56, 57, 59) including a power module (56); and
a cooling member (60) in which a refrigerant of the refrigerant circuit (20) flows, and which contacts the power module (56) so that the power module (56) is cooled by the refrigerant, wherein
the cooling member (60) includes a preventing unit that prevents cold heat of the refrigerant flowing in the cooling member (60) from being transferred to outside from at least a non-contact surface (60b) other than a contact surface (60a) of the cooling member (60) with the power module (56).

2. The refrigeration apparatus of claim 1, wherein
the cooling member (60) includes a main body (61) in which a cooling refrigerant configured to cool the power module (56) flows, and which contacts the power module (56), and
the preventing unit is formed by a thermal insulation layer (65) that covers a non-contact surface other than a contact surface (61s) of the main body (61) with the power module (56).

3. The refrigeration apparatus of claim 1, wherein
the preventing unit includes a high temperature refrigerant flow path (61b) in which a high temperature refrigerant flows, and the high temperature refrigerant flow path (61b) is formed on a side of the non-contact surface (60b) with respect to a cooling refrigerant flow path (61a) of the cooling member (60) in which the cooling refrigerant flows.

4. The refrigeration apparatus of claim 3, wherein
the preventing unit has a thermal insulation layer (68) formed between the cooling refrigerant flow path (61a) and the high temperature refrigerant flow path (61b).

5. The refrigeration apparatus of claim 4, wherein
the thermal insulation layer (68) is formed by a vacuum layer or an air layer.

6. The refrigeration apparatus of any one of claims 1 to 5, wherein
a decompression mechanism (81), which decompresses the refrigerant of the refrigerant circuit (20) and generates the cooling refrigerant, is provided in the cooling member (60).

7. The refrigeration apparatus of claim 6, wherein
the cooling member (60) is configured so that the cooling refrigerant, which has cooled the power module (56), exchanges heat with the refrigerant located upstream of the decompression mechanism (81) in the cooling member (60).

8. The refrigeration apparatus of claim 6, wherein
a thermal insulation pipe (85) is connected to a refrigerant outlet of the cooling member (60).

9. The refrigeration apparatus of any one of claims 1 to 8, wherein
the preventing unit is configured to prevent the cold heat of the refrigerant flowing in the cooling member (60) from being transferred to the outside from an outer edge of the contact surface (60a) of the cooling member (60) with the power module (56).

10. The refrigeration apparatus of claim 9, wherein
the preventing unit is configured so that a heat transfer surface, which transfers the cold heat of the refrigerant flowing in the cooling member (60) to the power module (56), has a smaller area than a surface of the power module (56), which corresponds to the cooling member (60).

11. The refrigeration apparatus of any one of claims 1 to 10, wherein
a non-contact surface, which is a surface of the power module (56) other than a contact surface with the cooling member (60), is covered by a thermal insulation layer (66).

12. The refrigeration apparatus of claim 2 or 4, wherein
the thermal insulation layer (65, 68) is comprised of an insert-molded insulating resin.

13. The refrigeration apparatus of any one of claims 2, 4, and 11, wherein
the thermal insulation layer (65, 66, 68) is formed by spraying urethane.
